# EUROPÄISCHE PATENTSCHRIFT

(11) **EP 1 805 818 B1**
(45) Veröffentlichungstag und Bekanntmachung des Hinweises auf die Patenterteilung: **14.12.2011**
(21) Anmeldenummer: 05797318.2
(22) Anmeldetag: 18.10.2005
(51) Int. Cl.: H01L 41/04, G05F 1/46

(54) **HYBRIDE ANSTEUERSCHALTUNG**
HYBRID CONTROL CIRCUIT
CIRCUIT D'EXCITATION HYBRIDE

(30) Priorität: 27.10.2004 DE 102004052248
(43) Veröffentlichungstag der Anmeldung: 11.07.2007
(73) Patentinhaber: Noliac A/S, 3490 Kvistgaard (DK)
(72) Erfinder: BACHMAIER, Georg, 80538 München (DE); GOTTLIEB, Bernhard, 81739 München (DE); KAPPEL, Andreas, 85649 Brunnthal (DE); SCHWEBEL, Tim, 80337 München (DE); TUMP, Christian, 80469 München (DE); WALLENHAUER, Carsten, 01987 Schwarzheide (DE)
(74) Vertreter: Hertling, Peter
(86) Internationale Anmeldenummer: PCT/EP2005/055341
(87) Internationale Veröffentlichungsnummer: WO 2006/045719

(56) Entgegenhaltungen:
- WO-A-02/25747
- DE-A1- 19 825 210
- US-A- 4 410 951

## Beschreibung

Die vorliegende Erfindung betrifft eine Vorrichtung zur Ansteuerung einer kapazitiven Last, insbesondere eines piezoelektrischen Aktors, aufweisend einen Signalgenerator zur Ansteuerung einer ersten Endstufe bzw. Einrichtung zur Erzeugung eines-diskreten Signals an der kapazitiven Last.

Für den Einsatz piezoelektrischer Aktoren in Anwendungen der Automobiltechnik, der Gebäudetechnik und der Automatisierungstechnik werden Ansteuerungen benötigt, die Spannungs-Zeitfunktionen mit großen Flankensteilheiten und hohen Endspannungen an kapazitiven Lasten erzeugen können. Um einen hohen Wirkungsgrad zu erzielen, werden zur Ansteuerung dieser Aktoren schaltende Endstufen verwendet. Aus der diskontinuierlichen Zuführung von Energie resultieren jedoch hohe Oberwellenpegel und Abweichungen der Aktorauslenkung von der Vorgabefunktion. Den Vorteilen eines hohen Wirkungsgrades, kleiner Anstiegszeiten und hoher Endspannungen stehen ein großer Oberwellenanteil und Abweichungen vom Sollwert gegenüber. Insbesondere bei der Verwendung zur Ansteuerung der Aktoren eines Piezomotors kommt es bei großem Oberwellenanteil zu starker Geräuschentwicklung. Ein potentieller Vorteil des piezoelektrischen Antriebs, die Laufruhe, bleibt dadurch ungenutzt.

Regelabweichungen und Oberwellen, die durch diskrete Energiepakete von geschalteten Endstufen bedingt sind, lassen sich durch Anpassen der Endstufen an die piezoelektrischen Aktoren und die zu erzielenden Zeitfunktionen reduzieren.

Dieser Reduktion sind jedoch Grenzen durch den Dynamikbereich der verwendeten Schaltung und Bauteile, sowie dem schaltungstechnischen Aufwand gesetzt. So können die von einer schaltenden Endstufe erzeugten "Ladungspakete" nur in Grenzen skaliert werden. Eine Endstufe mit kleinen Anstiegszeiten erzeugt nicht beliebig kleine Ladungspakete. Ein vorgegebener Sollwert wird daher nicht ohne Regelabweichung erreicht. Oberwellen, erzeugt durch den getakteten Betrieb und dem aus den Regelabweichungen resultierenden hohen Klirrfaktor der generierten Ansteuerfunktion, lassen sich zwar durch Filter dämpfen. Doch insbesondere wenn Nutz- und Oberwellenfrequenzen im Frequenzband dicht beieinander liegen oder hohe Störpegel zu dämpfen sind, ist der Aufwand außerordentlich hoch und der Wirkungsgrad wird verschlechtert.

Das Dokument US 4,410,951 A zeigt eine Vorrichtung zum Ansteuern einer kapazitiven Last basierend auf dem Oberbegriff des Anspruchs 1.

In den Dokumenten DE 198 25 210 A1 und WO 02/25747 A2 werden Schaltungsanordnungen beschrieben, welche eine kapazitive Last ansteuern, wobei eine erste Endstufe den Großteil der Spannung bzw. des Stroms an die kapazitive Last liefert. Die Schaltungsanordnungen dieser Dokumente umfassen ferner eine zweite Endstufe zur Feinregelung des der kapazitiven Last zugeführten Stroms, wobei die zweite Endstufe in dem Dokument DE 198 25 210 A1 eine analoge Endstufe und die zweite Endstufe in dem Dokument WO 02/25747 A2 eine lineare Endstufe ist. Die beiden Druckschriften behandeln nicht die Erzeugung von diskreten Signalen durch die erste Endstufe.

Es ist Aufgabe der vorliegenden Erfindung, bei einer Vorrichtung gemäß dem Oberbegriff des Hauptanspruchs kapazitive Lasten derart anzusteuern, dass mit Bezug auf eine Vorgabefunktion erfolgende Abweichungen der Signalgröße an der kapazitiven Last bzw. Abweichungen der Aktorauslenkung und ein Oberwellenpegel gegenüber herkömmlichen Ansteuerschaltungen wirksam verringert sind.

Die Aufgabe wird durch eine Vorrichtung gemäß dem Hauptanspruch und durch ein Verfahren gemäß dem Nebenanspruch gelöst. Die Unteransprüche geben vorteilhafte Ausführungsformen an.

Ein Signalgenerator erzeugt mittels eines einer Vorgabefunktion entsprechenden kontinuierlichen Signals an einer ersten Endstufe bzw. Einrichtung ein diskretes Signal an der kapazitiven Last. Mittels einer zweiten Endstufe bzw. Einrichtung erfolgt die Erzeugung eines kontinuierlichen Signals an der kapazitiven Last in Abhängigkeit von einer Vorgabefunktion des Signalgenerators und eines tatsächlichen diskreten Signals an der kapazitiven Last. Damit erfolgt eine Gegenkopplung einer Abweichung eines tatsächlichen diskreten Signals von einem geforderten kontinuierlichen Signal an der kapazitiven Last. Die Abweichung wird mittels einer Vergleichseinrichtung erfasst, die die zweite Endstufe bzw. Einrichtung ansteuert. Zeit- und wert- kontinuierliche Signale sind insbesondere stetige Signale. Diskrete Signale können zeit- oder wert-diskret sein.

Mittels einer Kombination aus einer Vorrichtung zur Erzeugung diskreter Signale und einer Vorrichtung zur Erzeugung eines kontinuierlichen Signals wird eine genaue und oberwellenarme Ansteuerung eines piezoelektrischen Aktors bewirkt. Das diskrete Signal ist insbesondere ein zeitdiskretes Signal, und zwar insbesondere ein Taktsignal, insbesondere mit konstantem oder variablem Endpegel und/oder variabler Zeitdauer. Insbesondere bei Verwendung von piezoelektrischen Aktoren sind die Taktsignale Spannungs-Zeitfunktionen mit großen Flankensteilheiten und hohen Endspannungen. Das kontinuierliche Signal ist insbesondere ein zeitkontinuierliches Signal. Aufgrund der Gegenkopplung einer Abweichung des tatsächlichen diskreten Signals von einer Vorgabefunktion mittels des durch den zweiten Signalgenerator erzeugten kontinuierlichen Signals können Klirrfaktor und Oberwellenpegel wirksam reduziert werden.

Gemäß einer vorteilhaften Ausgestaltung erzeugt der Signalgenerator zur Ansteuerung der ersten und der zweiten Endstufe mindestens eine Vorgabefunktion, insbesondere ein kontinuierliches Signal.

Die Vergleichseinrichtung kann zusätzlich einen Verstärker, insbesondere zur Verstärkung der Differenz zwischen dem geforderten kontinuierlichen Signal des Signalgenerators mit dem tatsächlichen diskreten Signal an der kapazitiven Last, aufweisen. Über eine Vergleichseinrichtung und eventuell Verstärker kann der Istwert des diskreten Signals an der kapazitiven Last mit dem einer Vorgabefunktion entsprechenden Sollwert verglichen werden. Der Sollwert wird von dem Signalgenerator der Vergleichseinrichtung zugeführt. Nachdem das Ansteuersignal gegebenenfalls verstärkt wurde, wird die zweite Endstufe entsprechend dem Vergleichsergebnis angesteuert. Als Vergleichseinrichtung und/oder Verstärker eignet sich bevorzugt ein Operationsverstärker.

Gemäß einer vorteilhaften Ausgestaltung ist die erste Endstufe als geregelte getaktete Endstufe bereitgestellt. Die erste Endstufe kann ebenso ungeregelt ausgeführt sein.

Weiterhin ist es besonders vorteilhaft, wenn ein Messwertaufnehmer an der kapazitiven Last zur Erfassung des Istwerts der Signalgröße, auf die geregelt werden soll, bereitgestellt ist. Der Messwertaufnehmer kann beispielsweise Spannung, Strom, Ladung oder Energie bzw. Leistung erfassen. Der Messwertaufnehmer ist dazu insbesondere in Reihe oder parallel zur kapazitiven Last elektrisch angeschlossen. Die Messwerterfassung kann auch berührungslos erfolgen.

Gemäß vorteilhaften Ausführungsformen kann der Signalgenerator direkt oder indirekt über eine entsprechende Endstufe eine Ladung, eine Spannung oder allgemein Energie an der kapazitiven Last bereitstellen.

Weiterhin ist es vorteilhaft, wenn die zweite Endstufe eine variable Spannungsquelle und einen Kondensator aufweist, die zueinander in Reihe oder parallel elektrisch angeschlossen sind.

Zur Kompensation von Drifteffekten, die zum Verlassen des Regelbereichs der zweiten Endstufe führen können, ist vorteilhaft ein Kompensationselement an der kapazitiven Last bzw. an dem Kondensator elektrisch angeschlossen.

Es ist besonders vorteilhaft, wenn das Kompensationselement ein parallel zur kapazitiven Last bzw. dem Kondensator elektrisch angeschlossener Widerstand oder Schalter ist.

Die vorliegende Erfindung wird anhand von Ausführungsbeispielen in Verbindung mit den Figuren näher beispielhaft beschrieben. Es zeigen:
- Fig. 1: zeigt einen schematischen Gesamtaufbau zur Veranschaulichung des Prinzips der vorliegenden Erfindung;
- Fig. 2: zeigt ein erstes Ausführungsbeispiel einer Vorrichtung gemäß der vorliegenden Erfindung;
- Fig. 3: zeigt ein zweites Ausführungsbeispiel einer Vorrichtung gemäß der vorliegenden Erfindung;
- Fig. 4: zeigt eine Simulationsschaltung mit einem Ladungsgenerator und einem kontinuierlichen Regler;
- Fig. 5: zeigt eine Simulationsschaltung ohne kontinuierlichem Regler;
- Fig. 6: zeigt Spannungs-Zeitfunktionen einer Schaltung nach Figur 4 (geregelt) und nach Fig. 5 (ungeregelt).

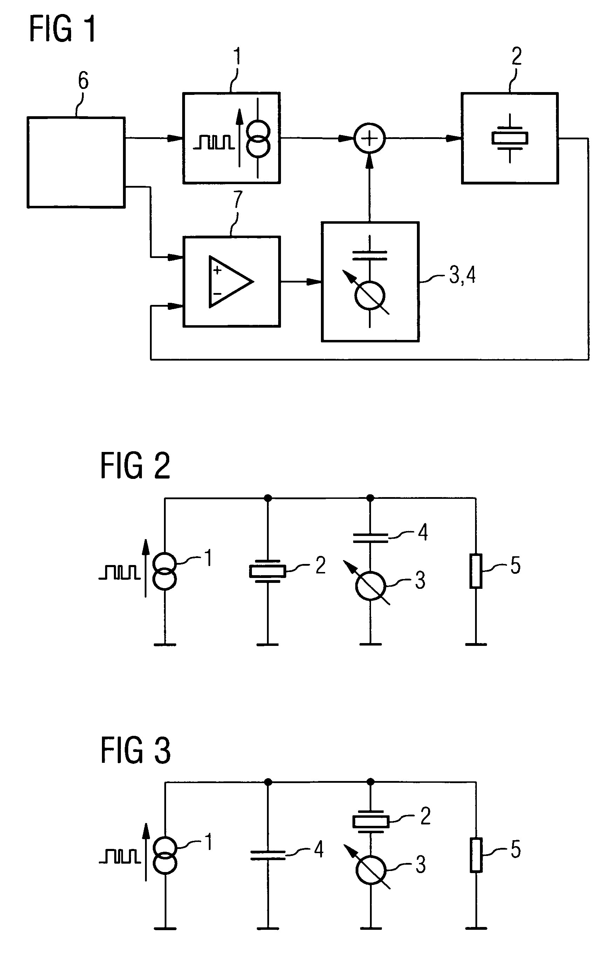

In Figur 1 ist schematisch der Gesamtaufbau für eine Aktoransteuerung nach dem erfindungsgemäßen Prinzip dargestellt. Der Aufbau besteht aus einem Signalgenerator 6, eine erste Endstufe 1 (Ladungsgenerator), einem Analogregler aus den Komponenten 7, 3, 4 und einer Last 2.

Der Signalgenerator 6 erzeugt die Vorgabefunktion, die grob durch die erste Endstufe 1 nachgebildet wird. Ein (nicht dargestellter) Messwertaufnehmer am Aktor 2 ermittelt den Istwert der Größe, auf die geregelt werden soll. Dies können zum Beispiel Spannung, Ladung oder Energie sein. Der Istwert wird der Vergleichseinrichtung/Verstärker 7 zugeführt, die das Signal mit einem Vorgabewert des Signalgenerators 6 vergleicht und eine Stellgröße erzeugt. Mit diesem Wert wird die variable Spannungsquelle 3 angesteuert, wodurch eine Ladung vom Kondensator 4 auf den Aktor 2 verschoben wird. Der aufgetretene Fehler wird dadurch korrigiert.

Das in Figur 2 dargestellte erste Ausführungsbeispiel löst wirkungsvoll die bei herkömmlichen Vorrichtungen gegebenen technischen Probleme. Ebenso durch Kombination aus einer getakteten Endstufe und einer Endstufe mit zeitkontinuierlichem Ausgangssignal werden die Nachteile der getakteten Endstufe ausgeglichen. Regelabweichungen und Oberwellen werden durch die zeitkontinuierliche Regelung über eine große Bandbreite hinweg kompensiert.

Ebenso durch die in Figur 2 dargestellte Schaltung werden beide Konzepte unter Nutzung der jeweiligen Vorteile zusammengeführt. Die getaktete Endstufe 1 erzeugt dabei die durch den Signalgenerator 6 vorgegebene Basiszeitfunktion der Ladung, Energie, Leistung, Strom oder Spannung an einem piezoelektrischen Aktor 2. Fig. 2 zeigt einen Ladungsgenerator 1 als Ausführungsbeispiel für eine getaktete Endstufe. Durch eine zweite Endstufe bzw. einen zweiten Signalgenerator, bestehend aus einem Zweig mit einer variablen Spannungsquelle 3 und einem Kondensator 4, werden geringe Ladungsmengen dem piezoelektrischen Aktor 2 entnommen oder zugeführt. Über einen Regelkreis, der sensitiv zur Piezoladung, Energie oder Spannung ist, wird die variable Spannungsquelle 3 angesteuert. Da hier die Anforderungen an den Spannungshub und die Ströme im Vergleich zur getakteten Endstufe klein sind, lassen sich hohe Grenzfrequenzen des Regelkreises erreichen. Der kontinuierliche Regler ist dadurch in der Lage, Oberwellen und Abweichungen vom Sollwert über eine große Bandbreite hinweg zu kompensieren.

Gemäß einem zweiten Ausführungsbeispiel nach Fig. 3 ist eine variable Spannungsquelle 3 elektrisch in Serie zu einem Aktor 2 angeordnet. Aktor 2 und variable Spannungsquelle 3 sind ebenso elektrisch parallel zu einem Kondensator bzw. zu einer Kapazität 4 angeschlossen. Eine Vorrichtung gemäß Fig. 3 hat eine vergleichbare Funktionsweise wie ein Aufbau nach Fig. 2, jedoch wird im Unterschied zu Fig. 2 das Bezugspotential des Aktors 2 verschoben. Die Kapazität 4 nimmt die dadurch verschobene Ladung auf.

Ein Element 5 in den Figuren 2 und 3 dient zur Kompensation von Drifteffekten, die zum Verlassen des Regelbereichs des kontinuierlichen Reglers bzw. des zweiten Signalgenerators führen können. Im einfachsten Fall ist Element 5 ein elektrischer Widerstand. Falls der Aktor 2 zyklisch angesteuert wird, kann das Element 5 als Schalter ausgeführt sein, der bei jedem Nulldurchgang der Vorgabefunktion die Kapazitäten 2 und 4 entlädt. In diesem Fall wird beim Nulldurchgang ebenso die Spannungsquelle 3 auf Null geregelt.

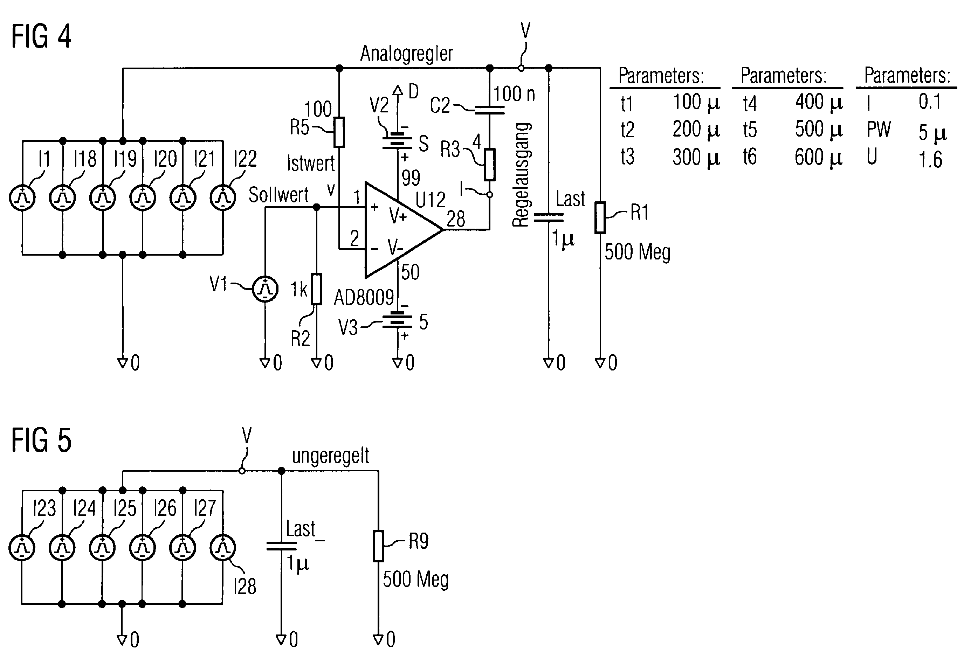

Das Wirkprinzip der vorliegenden Erfindung wurde mit Hilfe von Simulationen und anhand eines Testaufbaus nachgewiesen. Die Simulation ist durch Fig. 4, Fig. 5 und Fig. 6 dokumentiert.

In Fig. 4 ist die Simulationsschaltung für eine hybride Endstufe mit einem Ladungsgenerator (gepulste Stromquellen) und einem kontinuierlichen (analogen) Regler, im Wesentlichen aus einem schnellen Operationsverstärker bestehend, dargestellt.

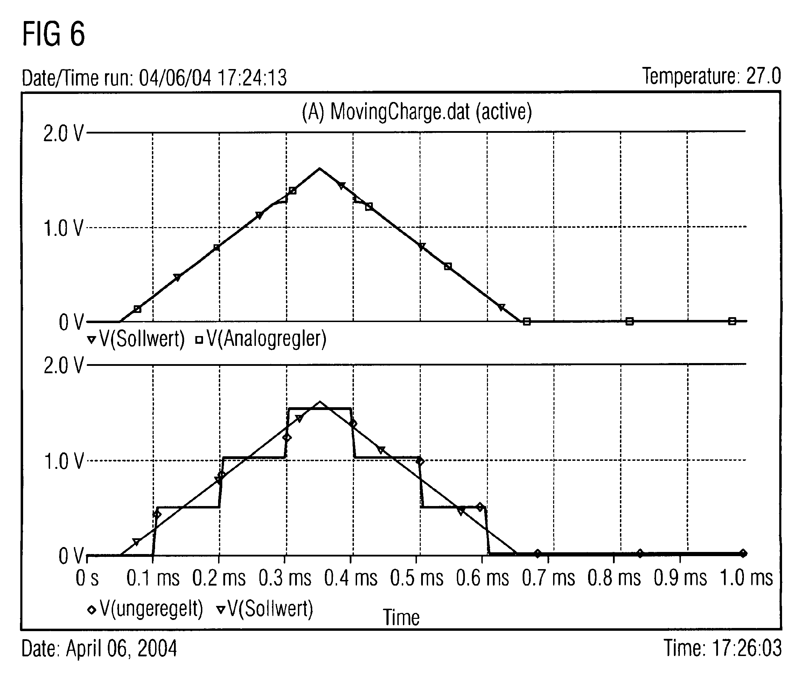

Als Vergleich zu Fig. 4 dient die Schaltung nach Fig. 5, die ohne kontinuierlichen Regler bereit gestellt ist. Diese Schaltung erzeugt die ungeregelte Spannungs-Zeitfunktion V(ungeregelt) nach Fig. 6 (siehe unteres Zeitdiagramm). Die durch den Spannungsgenerator verursachten Sprünge werden hier deutlich sichtbar. Die Zeitfunktion des Sollwerts V(Sollwert), die eine Dreieckfunktion ist, ist im gleichen Diagramm dargstellt.

Durch Verwendung der geregelten Schaltung nach Fig. 4 werden die Abweichungen der Spannung über der Last von der Sollspannung wirkungsvoll reduziert. Die Spannungs-Zeitfunktion V(Analogregler) bestätigt die Wirkung durch die geringen Abweichungen von der Sollfunktion (siehe Fig. 6; oberes Zeitdiagramm).

In der Praxis sind die durch die getaktete Endstufe erzeugten Sprünge kleiner und die Endspannungen höher. Die Ankopplung des kontinuierlichen Reglers (die Gewinnung des Istwertes) erfolgt dann über einen Spannungsteiler. Die Leistungsfähigkeit unter diesen Bedingungen konnte ebenso anhand eines Testaufbaus bestätigt werden.

## Patentansprüche

1. Vorrichtung zur Ansteuerung einer kapazitiven Last, insbesondere eines piezoelektrischen Aktors (2), aufweisend einen Signalgenerator (6) zur Ansteuerung einer ersten Endstufe (1) zur Erzeugung eines diskreten Signals an der kapazitiven Last,
**gekennzeichnet durch**
eine zweite Endstufe (3, 4) zur Erzeugung eines kontinuierlichen Signals an der kapazitiven Last,
eine Vergleichseinrichtung (7) zur Ansteuerung der zweiten Endstufe (3, 4), wobei
die Vergleichseinrichtung (7) ein gefordertes kontinuierliches Signal des Signalgenerators (6) mit dem tatsächlichen diskreten Signal an der kapazitiven Last vergleicht und die Abweichung des tatsächlichen diskreten Signals von dem geforderten kontinuierlichen Signal erfasst, wobei mittels des kontinuierlichen Signals der zweiten Endstufe (3, 4) im Betrieb der Vorrichtung ein Gegenkoppeln der Abweichung an der kapazitiven Last erfolgt.

2. Vorrichtung nach Anspruch 1,
**dadurch gekennzeichnet, dass**
der Signalgenerator (6) zur Ansteuerung der ersten Endstufe (1) und zweiten Endstufe (3, 4) mindestens eine Vorgabefunktion, insbesondere ein kontinuierliches Signal, erzeugt.

3. Vorrichtung nach Anspruch 1 oder 2,
**dadurch gekennzeichnet, dass**
die Vergleichseinrichtung (7) zusätzlich einen Verstärker aufweist.

4. Vorrichtung nach einem oder mehreren der Ansprüche 1 bis 3,
**dadurch gekennzeichnet, dass**
die erste Endstufe (1) als geregelte getaktete Endstufe bereit gestellt ist.

5. Vorrichtung nach einem oder mehreren der Ansprüche 1 bis 4,
**dadurch gekennzeichnet, dass**
ein Messwertaufnehmer an der kapazitiven Last zur Erfassung des Istwerts der Signalgröße, auf die geregelt werden soll, bereitgestellt ist.

6. Vorrichtung nach einem oder mehreren der Ansprüche 1 bis 5,
**dadurch gekennzeichnet, dass**
der Signalgenerator (6) eine Ladung, eine Spannung oder allgemein Energie bereitstellt.

7. Vorrichtung nach einem oder mehreren der Ansprüche 1 bis 6,
**dadurch gekennzeichnet, dass**
die zweite Endstufe (3, 4) eine variable Spannungsquelle (3) und einen Kondensator (4) aufweist.

8. Vorrichtung nach Anspruch 7,
**dadurch gekennzeichnet, dass**
ein Element (5) zur Kompensation von Drifteffekten an der kapazitiven Last bzw. dem Kondensator (4) elektrisch angeschlossen ist.

9. Vorrichtung nach Anspruch 8,
**dadurch gekennzeichnet, dass**
das Element (5) zur Kompensation von Drifteffekten ein parallel zur kapazitiven Last bzw. dem Kondensator (4) elektrisch angeschlossener Widerstand oder Schalter ist.

10. Verfahren zur Verwendung einer Vorrichtung nach einem oder mehreren der Ansprüche 1 bis 9, umfassend
ein mit einem Signalgenerator (6) und einer ersten, diskrete Signale ausgebenden Endstufe (1) erfolgendes Ansteuern einer kapazitiven Last mit einem diskreten Signal,
**gekennzeichnet durch**
ein mittels eines kontinuierlichen Signals einer zweiten Endstufe (3, 4) erfolgendes Gegenkoppeln einer Abweichung eines tatsächlichen diskreten Signals von einem geforderten kontinuierlichen Signal an der kapazitiven Last.

## Claims

1. Device for controlling a capacitive load, in particular a piezoelectric actuator (2), comprising a signal generator (6) for controlling a first end stage (1) for producing a discrete signal at the capacitive load,
**characterised by**
a second end stage (3, 4) for producing a continuous signal at the capacitive load,
a comparison device (7) for controlling the second end stage (3, 4), wherein
the comparison device (7) compares a required continuous signal of the signal generator (6) with an actual discrete signal at the capacitive load and detects the deviation of the actual discrete signal from the required continuous signal, thereby providing a feedback of the deviation at the capacitive load by means of the continuous signal of the second end stage (3, 4) during operation of the device.

2. Device according to claim 1, **characterised in that** the signal generator (6), for controlling the first end stage (1) and second end stage (3, 4), creates at least one setpoint function, in particular a continuous signal.

3. Device according to claim 1 or 2, **characterised in that** the comparison device (7) additionally comprises an amplifier.

4. Device according to one or more of claims 1 to 3, **characterised in that** the first end stage (1) is provided as a regulated clocked end stage.

5. Device according to one or more of claims 1 to 4, **characterised in that** a measured value recorder is provided at the capacitive load for detection of the actual value of the signal variable to which the signal is to be regulated.

6. Device according to one or more of claims 1 to 5, **characterised in that** the signal generator (6) provides a charge, a voltage or energy in general.

7. Device according to one or more of claims 1 to 6, **characterised in that** the second end stage (3, 4) features a variable voltage source (3) and a capacitor (4).

8. Device according to claim 7, **characterised in that** an element (5) to compensate for drift effects is electrically connected to the capacitive load or the capacitor (4).

9. Device according to claim 8, **characterised in that** the element (5) to compensate for drift effects is a resistor or a switch electrically connected in parallel to the capacitive load or the capacitor (4).

10. Method for using a device according to one or more of the claims 1 to 9 comprising: controlling a capacitive load with a discrete signal by a signal generator (6) and a first end stage (1) outputting discrete signals,
**characterised by**
providing a feedback of a deviation of an actual discrete signal from a required continuous signal at the capacitive load by means of a continuous signal of a second end stage (3, 4).

## Revendications

1. Dispositif pour activer une charge capacitive, en particulier un actionneur (2) piézoélectrique, comportant un générateur de signaux (6) pour activer un premier étage de sortie (1) destiné à délivrer un signal discret à la charge capacitive,
**caractérisé par**
un deuxième étage de sortie (3, 4) destiné à délivrer un signal continu à la charge capacitive,
le dispositif de comparaison (7) comparant un signal continu demandé du générateur de signaux (6) avec le signal discret réel sur la charge capacitive et enregistrant la divergence entre le signal discret réel et le signal continu demandé,
une contre-réaction de la divergence sur la charge capacitive se produisant au moyen du signal continu du deuxième étage de sortie (3, 4) en cours de service du dispositif.

2. Dispositif selon la revendication 1, **caractérisé en ce que** le générateur de signaux (6) destiné à activer le premier étage de sortie (1) et le deuxième étage de sortie (3, 4) génère au moins une fonction de référence, en particulier un signal continu.

3. Dispositif selon la revendication 1 ou 2, **caractérisé en ce que** le dispositif de comparaison (7) comporte, en plus, un amplificateur.

4. Dispositif selon une ou plusieurs des revendications 1 à 3, **caractérisé en ce que** le premier étage de sortie (1) est mis à disposition en tant qu'étage de sortie réglé cadencé.

5. Dispositif selon une ou plusieurs des revendications 1 à 4, **caractérisé en ce qu'**un transducteur est mis à disposition sur la charge capacitive pour enregistrer la valeur réelle de la grandeur du signal, qui doit être réglée.

6. Dispositif selon une ou plusieurs des revendications 1 à 5, **caractérisé en ce que** le générateur de signaux (6) met à disposition une charge, une tension ou, en général, une énergie.

7. Dispositif selon une ou plusieurs des revendications 1 à 6, **caractérisé en ce que** le deuxième étage de sortie (3, 4) comporte une source de tension (3) variable et un condensateur (4).

8. Dispositif selon la revendication 7, **caractérisé en ce qu'**un élément (5) destiné à compenser les effets de dérive est raccordé électriquement à la charge capacitive ou au condensateur (4).

9. Dispositif selon la revendication 8, **caractérisé en ce que** l'élément (5) destiné à compenser les effets de dérive est une résistance ou un commutateur raccordé électriquement en parallèle avec la charge capacitive ou le condensateur (4).

10. Procédé pour utiliser un dispositif selon une ou plusieurs des revendications 1 à 9, comprenant une activation, obtenue avec un générateur de signaux (6) et un premier étage de sortie (1) délivrant des signaux discrets, d'une charge capacitive avec un signal discret,
**caractérisé par**
une contre-réaction, obtenue au moyen d'un signal continu d'un deuxième étage de sortie (3, 4), d'une divergence entre un signal discret réel et un signal continu demandé sur la charge capacitive.
